(19) Europäisches Patentamt
European Patent Office
Office européen des brevets

(11) Veröffentlichungsnummer: **0 126 712**
**B1**

# (12) EUROPÄISCHE PATENTSCHRIFT

(45) Veröffentlichungstag der Patentschrift: **10.12.86**

(51) Int. Cl.⁴: **G 03 C 1/68,** C 08 F 4/42, C 08 G 59/68, C 08 K 5/00

(21) Anmeldenummer: **84810232.3**

(22) Anmeldetag: **14.05.84**

## (54) Härtbare Zusammensetzung und deren Verwendung.

(30) Priorität: **18.05.83 CH 2691/83**

(43) Veröffentlichungstag der Anmeldung: **28.11.84 Patentblatt 84/48**

(45) Bekanntmachung des Hinweises auf die Patenterteilung: **10.12.86 Patentblatt 86/50**

(84) Benannte Vertragsstaaten: **AT BE CH DE FR GB IT LI NL SE**

(56) Entgegenhaltungen:
**EP-A-0 094 915**
**DE-A-2 025 814**
**GB-A-2 051 071**

(73) Patentinhaber: **CIBA-GEIGY AG, Klybeckstrasse 141, CH-4002 Basel (CH)**

(72) Erfinder: **Meier, Kurt, Dr., Ulmenstrasse 11, CH-4123 Allschwil (CH)**
Erfinder: **Eugster, Giuliano, Dorfstrasse 35, CH-4452 Itingen (CH)**
Erfinder: **Schwarzenbach, Franz, Mischelistrasse 59, CH-4153 Reinach (CH)**
Erfinder: **Zweifel, Hans, Dr., Lothringerstrasse 93, CH-4056 Basel (CH)**

EP 0 126 712 B1

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

ACTORUM AG

**Beschreibung**

Die vorliegende Erfindung betrifft eine härtbare Zusammensetzung aus a) einem kationisch und/oder radikalisch polymerisierbarem Material, b) einem Eisen(II)-Aromaten-Komplex und c) einem Oxidationsmittel, ein Verfahren zum Polymerisieren solchen Materials durch Strahlungseinwirkung, ein mit der Zusammensetzung beschichtetes Material und dessen Verwendung.

Aus der Literatur ist bekannt, dass z.B. Jodonium-, Sulfonium- und Diazoniumsalze geeignete Photoinitiatoren für die strahlungsinduzierte Polymerisation von kationisch polymerisierbarem, organischem Material sind (siehe beispielsweise deutsche Auslegeschrift 2 518 639, J. Polym. Sci., Polymer Chemistry Ed., *17*, 1059 (1979), Makromol. Chem., Suppl. *3*, 348 (1979), deutsche Offenlegungsschriften 2 520 489, 2 854 011 und 3 021 376, U.S. Patentschrift 4 210 449 und britische Patentanmeldung 2 046 269A). Wegen ihres verhältnismässig tiefliegenden Absorptionsbereichs (etwa 190 bis 400 nm) erfordern diese bekannten Photoinitiatoren die Verwendung von Sensibilisatoren wie farbigen polycyclischen Kohlenwasserstoffen, z.B. Perylenfarbstoffe, aromatische Amine, Benzoinalkyläther oder Alkoxyacetophenone, zur Härtung kationisch polymerisierbarer Systeme unter Lichteinwirkung. Die Heisshärtung von solchen Photoinitiatoren enthaltenden Systemen wird zweckmässig in Gegenwart von Reduktionsmitten wie Kupfer-, Zinn-, Eisen- oder Kobaltsalzen, Thiophenolen, Ascorbinsäure und dergleichen durchgeführt.

Eigene Untersuchungen (veröffentlicht in EP-A-94915 am 22. 11. 83) ergaben, dass Metallocenkomplexsalze Photoinitiatoren für kationisch polymerisierbare organische Materialien sind, die keine Mitverwendung von Sensibilisatoren erfordern. Diese Materialien können entweder direkt bei hohen Temperaturen oder nach Strahlungseinwirkung bei Temperaturen, die über der Bestrahlungstemperatur liegen, gehärtet werden. Es wäre vorteilhafter, wenn die Polymerisation bei noch niedrigeren Temperaturen durchgeführt werden könnte oder nur durch Strahlungseinwirkung und der Eigenerwärmung durch die Polymerisationswärme. Es ist auch wünschenswert, dass gleichzeitig kationisch, radikalisch oder nach beiden Mechanismen polymerisierbare organische Materialien mit einem Photoinitiator unter Strahlungseinwirkung polymerisiert werden können.

Aufgabe vorliegender Erfindung ist es, eine härtbare Zusammensetzung bereitzustellen, die diesen Anforderungen genügt.

Gegenstand vorliegender Erfindung ist eine härtbare Zusammensetzung, enthaltend

a) ein radikalisch oder kationisch polymerisierbares Material, Gemische dieser Materialien oder ein radikalisch und kationisch polymerisierbares Material

b) mindestens eine Eisenverbindung der Formel I

$$[(R^1)(R^2Fe^{II})_a]^{+a} \ \frac{a}{q} \ (LQ_m)^{-q} \qquad (I)$$

worin

a 1 oder 2 und q 1, 2 oder 3 sind,

L ein zweiwertiges bis siebenwertiges Metall oder Nichtmetall bedeutet,

Q für ein Halogenatom steht,

m eine ganze Zahl ist, die der Summe der Wertigkeit von L und q entspricht,

$R^1$ ein $\pi$-Aren und $R^2$ das Anion eines $\pi$-Arens bedeuten, und

c) mindestens einen Elektronenacceptor als Oxidationsmittel.

Als $\pi$-Arene $R^1$ kommen insbesondere aromatische Gruppen mit 6 bis 24 Kohlenstoffatomen oder heteroaromatische Gruppen mit 3 bis 20 Kohlenstoffatomen in Betracht, wobei diese Gruppen gegebenenfalls durch gleiche oder verschiedene einwertige Reste wie Halogenatome, vorzugsweise Chlor- oder Bromatome, oder $C_1$-$C_8$-Alkyl-, $C_2$-$C_8$-Alkenyl, $C_2$-$C_8$-Alkinyl, $C_1$-$C_8$-Alkoxy-, Cyan-, $C_1$-$C_8$-Alkylthio-, $C_2$-$C_6$-Monocarbonsäurealkylester-, Phenyl-, $C_2$-$C_5$-Alkanoyl- oder Benzoylgruppen einfach oder mehrfach substituiert sein können. Diese $\pi$-Arengruppen können einkernige, kondensierte mehrkernige oder unkondensierte mehrkernige Systeme darstellen, wobei in den zuletzt genannten Systemen die Kerne direkt oder über Brückenglieder wie -S- oder -O- verknüpft sein können.

$R^2$ als das Anion eines $\pi$-Arens kann ein Anion eines $\pi$-Arens der obengenannten Art sein, zum Beispiel das Indenylanion und insbesondere das Cyclopentadienylanion, wobei auch diese Anionen gegebenenfalls durch gleiche oder verschiedene einwertige Reste wie $C_1$-$C_8$-Alkyl-, $C_2$-$C_8$-Alkenyl, $C_2$-$C_8$-Alkinyl, $C_2$-$C_6$-Monocarbonsäurealkylester-, Cyan-, $C_2$-$C_5$-Alkanoyl- oder Benzoylgruppen einfach oder mehrfach substituiert sein können.

Die Alkyl-, Alkoxy-, Alkylthio-, Monocarbonsäurealkylester- und Alkanoylsunstituenten können dabei geradkettig oder verzweigt sein. Als typische Alkyl-, Alkoxy-, Alkylthio-, Monocarbonsäurealkylester- bzw. Alkanoylsubstituenten seien Methyl, Äthyl, n-Propyl, Isopropyl, n-Butyl, sek.-Butyl, tert.-Butyl, n-Pentyl, n-Hexyl und n-Octyl, Methoxy, Äthoxy, n-Propoxy, Isopropoxy, n-Butoxy, n-Hexyloxy und n-Octyloxy, Methylthio, Äthylthio, n-Propylthio, Isopropylthio, n-Butylthio, n-Pentylthio und n-Hexylthio, Carbonsäuremethyl-, -äthyl-, -n-propyl-, -isopropyl-, -n-butyl- und -n-pentylester bzw. Acetyl, Propionyl, Butyryl und Valeroyl genannt. Dabei sind Alkyl-, Alkoxy-, Alkylthio- und Monocarbonsäurealkylestergruppen mit 1 bis 4 und insbesondere 1 oder 2 Kohlenstoffatomen in den Alkylteilen sowie Alkanoylgruppen mit 2 oder 3 Kohlenstoffatomen bevorzugt. Als substituierte $\pi$-Arenen werden solche bevorzugt, die einen oder zwei der obengenannten Substituenten, insbesondere Chlor- oder Bromatome, Methyl-, Äthyl-, Methoxy-, Äthoxy-, Cyan-, Carbonsäuremethyl- oder -äthylestergruppen und Acetylgruppen, enthalten.

Als heteroaromatische $\pi$-Arene eignen sich S-, N- und/oder O-Atome enthaltende Systeme. Heteroaromatische $\pi$-Arene, die S- und/oder O-Atome enthalten, sind bevorzugt. Beispiele für geeignete $\pi$-Arene

sind Benzol, Toluol, Xylole, Äthylbenzol, Methoxybenzol, Äthoxybenzol, Dimethoxybenzol, p-Chlortoluol, Chlorbenzol, Brombenzol, Dichlorbenzol, Acetylbenzol, Trimethylbenzol, Trimethoxybenzol, Naphthalin, 1,2-Dihydronaphthalin, 1,2,3,4-Tetrahydronaphthalin, Methylnaphthaline, Methoxynaphthaline, Äthoxynaphthaline, Chlornaphthaline, Bromnaphthaline, Biphenyl, Inden, Biphenylen, Fluoren, Phenanthren, Anthracen, 9,10-Dihydroanthracen, Triphenylen, Pyren, Naphthacen, Coronen, Thiophen, Chromen, Xanthen, Thioxanthen, Benzolthiophen, Naphthothiophen, Thianthren, Diphenylenoxyd, Diphenylensulfid, Acridin und Carbazol.

Beispiele für Anionen substituierter $\pi$-Arene sind die Anionen des Methyl-, Äthyl-, n-Propyl- und n-Butylcyclopentadiens, die Anionen des Dimethylcyclopentadiens, der Cyclopentadiencarbonsäuremethyl- und -äthylester sowie des Acetylcyclopentadiens, Propionylcyclopentadiens, Cyancyclopentadiens und Benzoylcyclopentadiens. Bevorzugte Anionen sind das Anion des unsubstituierten Indens und insbesondere des unsubstituierten Cyclopentadiens.

Bevorzugt hat a den Wert 1, und $R^1$ steht für Benzol, Toluol, Xylol, Methoxybenzol, Chlorbenzol, p-Chlortoluol, Naphthalin, Methylnaphthalin, Chlornaphthalin, Methoxynaphthalin, Biphenyl, Inden, Pyren, Perylen oder Diphenylensulfid, und $R^2$ steht für das Anion des Cyclopentadiens, Acetylcyclopentadiens, Methylcyclopentadiens, Phenylcyclopentadiens oder Indens.

Besonders bevorzugt sind solche Komplexe der Formel I, worin a 1 ist, $R^1$ für $\eta^6$-Pyren oder $\eta^6$-Naphthalin und $R^2$ für das Anion des $\eta^5$-Cyclopentadiens stehen.

Beispiele für geeignete Metalle oder Nichtmetalle L sind Sb, Fe, Sn, Bi, Al, Ga, In, Ti, Zr, Sc, V, Cr, Mn und Cu; Lanthanide wie Ce, Pr und Nd oder Actinide wie Th, Pa, U oder Np. Geeignete Nichtmetalle sind insbesondere B, P und As. L ist vorzugsweise P, As, B oder Sb, wobei B besonders bevorzugt wird. Q als Halogenatom ist bevorzugt Cl und besonders F.

Komplexe Anionen $[LQ_m]^{-q}$ sind beispielsweise $BF_4^-$, $PF_6^-$, $AsF_6^-$, $SbF_6^-$, $FeCl_4^-$, $SnCl_6^{2-}$, $SbCl_6^-$ und $BiCl_6^-$. Die besonders bevorzugten komplexen Anionen sind $SbF_6^-$, $BF_4^-$, $AsF_6^-$ und $PF_6^-$.

Die Verbindungen der Formel I sind bekannt oder können nach analogen Verfahren hergestellt werden.

Bei den Elektronenacceptoren als Oxidationsmittel handelt es sich bevorzugt um ein organisches Hydroperoxid, eine organische Persäure oder ein Chinon.

Beispiele sind: Tertiärbutylhydroperoxid, Cumolhydroperoxid, Triphenylmethylhydroperoxid, Tetralinhydroperoxid, α-Methyltetralinhydroperoxid, Decalinhydroperoxid, Perbenzoesäure, m-Chlorperbenzoesäure oder Benzochinon.

Für die erfindungsgemässen härtbaren Zusammensetzungen geeignete, kationisch polymerisierbare organische Materialien sind beispielsweise solche der folgenden Arten, wobei diese für sich allein oder als Gemische von mindestens zwei Komponenten eingesetzt werden können:

I. Äthylenisch ungesättigte Verbindungen, die nach einem kationischen Mechanismus polymerisierbar sind. Dazu gehören

1. Mono- und Diolefine, z.B. Isobutylen, Butadien, Isopren, Styrol, α-Methylstyrol, Divinylbenzole, N-Vinylpyrrolidon, N-Vinylcarbazol und Acrolein.

2. Vinyläther, z.B. Methylvinyläther, Isobutylvinyläther, Trimethylolpropantrivinyläther, Äthylenglykoldivinyläther; cyclische Vinyläther, z.B. 3,4-Dihydro-2-formyl-2H-pyran (dimeres Acrolein) und der 3,4-Dihydro-2H-pyran-2-carbonsäureester des 2-Hydroxymethyl-3,4-dihydro-2H-pyrans.

3. Vinylester, z.B. Vinylacetat und Vinylstearat.

II. Kationisch polymerisierbare heterocyclische Verbindungen, z.B. Äthylenoxyd, Propylenoxyd, Epichlorhydrin, Glycidyläther einwertiger Alkohole oder Phenole, z.B. n-Butylglycidyläther, n-Octylglycidyläther, Phenylglycidyläther und Kresylglycidyläther; Glycidylacrylat, Glycidylmethacrylat, Styroloxyd und Cyclohexenoxyd; Oxetane wie 3,3-Dimethyloxyetan und 3,3-Di-(chlormethyl)-oxetan; Tetrahydrofuran; Dioxolane, Trioxan und 1,3,6-Trioxacyclooctan; Lactone wie β-Propiolacton, γ-Valerolacton und ε-Caprolacton; Thiirane wie Äthylensulfid und Propylensulfid; Azetidine wie N-Acylazetidine, z.B. N-Benzoylazetidin sowie die Addukte von Azetidin mit Diisocyanaten, z.B. Toluylen-2,4- und -2,6-diisocyanat und 4,4'-Diaminodiphenylmethandiisocyanat; Epoxiharze; lineare und verzweigte Polymere mit Glycidylgruppen in den Seitenketten, z.B. Homo- und Copolymere von Polyacrylat- und Polymethacrylat-glycidylestern.

Besonders wichtige unter diesen obengenannten polymerisierbaren Verbindungen sind die Epoxidharze und insbesondere die Di- und Polyepoxide und Epoxidharzpräpolymere der zur Herstellung vernetzter Epoxiharze verwendeten Art. Die Di- und Polyepoxide können aliphatische, cycloaliphatische oder aromatische Verbindungen sein. Beispiele für solche Verbindungen sind die Glycidyläther und β-Methylglycidyläther aliphatischer oder cycloaliphatischer Diole oder Polyole, zum Beispiel solche des Äthylenglykols, Propan-1,2-diols, Propan-1,3-diols, Butan-1,4-diols, Diäthylenglykols, Polyäthylenglykols, Polypropylenglykols, Glycerins, Trimethylolpropans oder 1,4-Dimethylolcyclohexans oder des 2,2-Bis-(4-hydroxycyclohexyl)-propans und N,N-Bis-(2-hydroxyäthyl)-anilins; die Glycidyläther von Di- und Polyphenolen, beispielsweise Resorcin, 4,4'-Dihydroxydiphenylmethan, 4,4'-Dihydroxydiphenyl-2,2-propan, Novolake und 1,1,2,2-Tetrakis-(4-hydroxyphenyl)-äthan. Weitere Beispiele sind N-Glycidylverbindungen z.B. die Diglycidylverbindungen des Äthylenharnstoffs, 1,3-Propylenharnstoffs oder 5-Dimethylhydantoins oder des 4,4'-Methylen-5,5'-tetramethyldihydantoins, oder solche wie Triglycidylisocyanurat.

Weitere Glycidylverbindungen mit technischer Bedeutung sind die Glycidylester von Carbonsäure, insbesondere Di- und Polycarbonsäuren. Beispiele dafür sind die Glycidylester der Bernsteinsäure, Adipinsäure, Azelainsäure, Sebacinsäure, Phthalsäure, Terephthalsäure, Tetra- und Hexahydrophthalsäure, Isophthalsäure oder Trimellitsäure, oder von dimerisierten Fettsäuren.

Beispiele für von Glycidylverbindungen verschiedene Polyepoxide sind die Diepoxide des Vinylcyclohexens und Dicyclopentadiens, 3-(3',4'-Epoxicyclohexyl)-8,9-epoxy-2,4-dioxaspiro[5.5]undecan, der 3',4'-Epoxicyclohexylmethylester der 3,4-Epoxicyclohexancarbonsäure, Butadiendiepoxid oder Isoprendiepoxid, epoxidierte Linolsäurederivate oder epoxidiertes Polybutadien.

Bevorzugte Epoxidharze sind gegebenenfalls vorverlängerte Diglycidyläther zweiwertiger Phenole oder zweiwertiger aliphatischer Alkohole mit 2 bis 4 Kohlenstoffatomen. Besonders bevorzugt werden die gegebenenfalls vorverlängerten Diglycidyläther des 2,2-Bis-(4-hydroxyphenyl)-propans und Bis-(4-hydroxyphenyl)-methans.

Als kationisch polymerisierbare Verbindungen kommen ferner in Betracht:

III. Methylolverbindungen:

1. Aminoplaste wie die N-Hydroxymethyl-, N-Methoxymethyl-, N-n-Butoxymethyl- und N-Acetoxymethylderivate von Amiden oder amidartigen Verbindungen, z.B. cyclischen Harnstoffen wie Äthylenharnstoff (Imidazolidin-2-on), Hydantoin, Uron (Tetrahydro-oxadiazin-4-on), 1,2-Propylenharnstoff (4-Methylimidazolidin-2-on), 1,3-Propylenharnstoff Hexahydro-2H-pyrimidin-2-on), Hydroxyxypropylenharnstoff (5-Hydroxyhexahydro--2H-pyrimidin-2-on), 1,3,5-Melamin und weitere Polytriazine wie Acetoguanamin, Benzoguanamin und Adipoguanamin.

Gewünschtenfalls kann man Aminplaste einsetzen, die sowohl N-Hydroxymethyl- als auch N-Alkoxymethyl- oder sowohl N-Hydroxymethyl- als auch N-Acetoxymethylgruppen enthalten (beispielsweise ein Hexamethylolmelamin, in dem 1 bis 3 der Hydroxylgruppen mit Methylgruppen veräthert sind).

Als Aminoplaste werden die Kondensationsprodukte von Harnstoff, Uron, Hydantoin oder Melamin mit Formaldehyd sowie teilweise oder völlig verätherte Produkte solcher Kondensationsprodukte mit einem aliphatischen einwertiger Alkohol mit 1 bis 4 Kohlenstoffatomen bevorzugt.

2. Phenolplaste.

Bevorzugte Phenolplaste sind aus einem Phenol und einem Aldehyd hergestellte Resole. Zu geeigneten Phenolen gehören Phenol selbst, Resorcin, 2,2-Bis-(p-hydroxyphenyl)-propan, p-Chlorphenol, ein durch eine oder zwei Alkylgruppen mit je 1 bis 9 Kohlenstoffatomen substituiertes Phenol, wie o-, m- und p-Kresol, die Xylenole, p-tert.-Butylphenol und p-Nonylphenol sowie auch phenylsubstituierte Phenole, insbesondere p-Phenylphenol. Der mit dem Phenol kondensierte Aldehyd ist vorzugsweise Formaldehyd, doch kommen auch andere Aldehyde wie Acetaldehyd und Furfurol in Frage. Gewünschtenfalls kann man ein Gemisch solcher härtbarer Phenol/Aldehydharze verwenden.

Die bevorzugten Resole sind Kondensationsprodukte des Phenols, p-Chlorphenols, Resorcins oder o-, m- oder p-Kresols mit Formaldehyd.

Geeignete radikalisch polymerisierbare organische Materialien sind besonders mono- oder polyäthylenisch ungesättigte Verbindungen. Beispiele sind: Styrol, Vinylpyridin, Vinylacetat, Divinylbenzol, Vinyläther, Acrylamid, Methacrylamid, Bisacrylamid, Bismethacrylamid, ungesättigte Polyester, insbesondere auf der Basis von Maleinsäure. Bevorzugte Materialien sind die Ester oder Amide von Arylsäure und/oder Methacrylsäure von linearen oder verzweigten Alkoholen, Polyolen bzw. Mono- oder Polyaminen. Bei den Polyolen und Polyaminen können auch Teilester vorliegen.

Beispiele für Polyamine sind Äthylen-, Propylen-, Butylen-, Hexylendiamin, Phenylendiamin, Benzylendiamin, Naphthylendiamin, Diäthylentriamin, Triäthylentetramin, Diaminoäthyläther. Beispiele für Polyole sind lineare und verzweigte Alkylendiole wie Äthylen-, Propylen-, Butylen-, Pentylen-, Hexylen-, Octylendiol, Polyoxaalkylendiole wie Diäthylen- und Triäthylenglykol und Polyäthylenglykole mit einem Molekulargewicht von 200 bis 500, 1,4-Dihydroxycyclohexan, 1,4-Di(hydroxymethyl)-cyclohexan, Dihydroxybenzole, Hydroxymethylphenole, Triole wie 1,2,3-Trihydroxypropan, 1,2,4-Trihydroxybutan, Trimethylolpropan, Pentaerythrit, Dipentaerythrit und niedermolekulare Polyester mit Hydroxylendgruppen.

Geeignete Alkohole und Monoamine sind z.B. Methanol, Äthanol Propanol, Butanol, Pentanol, Hexanol, Heptanol, Octanol, 2-Äthylhexanol, Cyclohexanol, Phenol, Glycidol, Methylamin, Dimethylamin, Äthylamin.

Kationisch und radikalisch polymerisierbare organische Materialien sind z.B. Mischungen der oben erwähnten kationisch bzw. radikalisch polymerisierbaren Materialien. Mischungen mit Epoxidharzen sind bevorzugt. Ferner sind Teilester von Epoxidharzen und Acrylsäure, Methacrylsäure oder einer Mischung dieser Säuren geeignet.

Die Eisenverbindung b) und das Oxyidationsmittel c) kann in einer Menge von 0,1 bis 15, vorzugsweise 0,5 bis 10 Gew.-% in der Zusammensetzung enthalten sein, bezogen auf das polymerisierbare organische Material. Das Gewichtsverhältnis der Eisenverbindung b) zu dem Oxidationsmittel c) kann von 1:10 bis 5:1, vorzugsweise von 1:5 bis 1:1, betragen.

Die erfindungsgemässen härtbaren Zusammensetzungen lassen sich z.B. als homogene flüssige Gemische oder in homogener oder inhomogener glasiger Form erhalten. Homogene glasige Produkte können in an sich bekannter Weise zum Beispiel durch Verflüssigung fester polymerisierbarer organischer Materialien, gegebenenfalls unter Zusatz geeigneter Lösungsmittel im Dunkeln oder unter rotem Licht, Erhitzen auf Temperaturen über ihren Glasübergangspunkt, Zugabe der Komponenten b) und c) und Abkühlung der entstandenen Gemische erhalten werden. Gewünschtenfalls kann man die so erhaltenen glasigen Produkte anschliessend zerkleinern. Inhomogene glasige Produkte können beispielsweise durch Vermischen glasiger polymerisierbarer Materialien in Pulverform mit den Komponenten b) und c) erhalten werden.

Die erfindungsgemässen Zusammensetzungen sind bei Raumtemperatur in verhältnismässiger Dunkelheit, z.B. in rotem Licht, stabil und somit lagerfähig. Sie können direkt heissgehärtet werden, zweckmässig bei Temperaturen, die nahe bei dem Schmelzpunkt oder Zersetzungspunkt der Komponenten b) und c) liegen.

Ein wesentlicher Vorteil der erfindungsgemässen Zusammensetzung ist, dass sie durch Einwirkung von Strahlung gehärtet werden kann, wobei die vollständige Aushärtung im allgemeinen durch die gebildete Reaktionswärme erfolgt und sich ein äusseres Erwärmen erübrigt. Es kann aber manchmal zweckmässig sein, zusätzlich eine äussere Erwärmung nach dem Belichten vorzunehmen, z.B. wenn kürzere Reaktionszeiten gewünscht sind.

Ein weiterer Gegenstand vorliegender Erfindung ist somit ein Verfahren zum Polymerisieren eines radikalisch oder kationisch polymerisierbaren organischen Materials, einer Mischung dieser Materialien oder eines radikalisch und kationisch polymerisierbaren Materials, unter Einwirkung von Strahlung in Gegenwart eines Photoinitiators und gegebenenfalls unter Erwärmen, das dadurch gekennzeichnet ist, dass der Photoinitiator eine Mischung aus

a) mindestens einer Eisenverbindung der Formel I

$$[(R^1)(R^2Fe^{II})_a]^{+a} \ \frac{a}{q} \ (LQ_m)^{-q} \qquad (I),$$

worin

a 1 oder 2 und q 1, 2 oder 3 sind,

L ein zweiwertiges bis siebenwertiges Metall oder Nichtmetall bedeutet,

Q für ein Halogenatom steht,

m eine ganze Zahl ist, die der Summe der Wertigkeit von L und q entspricht,

$R^1$ ein $\pi$-Aren und $R^2$ das Anion eines $\pi$-Arens bedeuten, und

b) mindestens einem Elektronenacceptor als Oxidationsmittel, ist, und dass man gegebenenfalls danach die Polymerisationsreaktion durch Wärmezufuhr vervollständigt.

Die Bestrahlung der härtbaren Gemische erfolgt zweckmässig mit Elektronenstrahlen oder aktinischem Licht, vorzugsweise einer Wellenlänge von 200 bis 600 nm und einer Intensität von 150 bis 5000 Watt. Als Lichtquellen eignen sich beispielsweise Xenonlampen, Argonlampen, Wolframlampen, Kohlelichtbögen, Metallhalogenid- und Metalllichtbogenlampen, wie Niederdruck-, Mitteldruck- und Hochdruckquecksilberlampen. Vorzugsweise wird die Bestrahlung mit Metallhalogenid- oder Hochdruckquecksilberlampen durchgeführt. Die Bestrahlungszeit hängt von verschiedenen Faktoren ab, einschliesslich z.B. dem polymerisierbaren organischen Material, der Art der Lichtquelle und deren Abstand vom bestrahlten Material. Die Bestrahlungszeit beträgt vorzugsweise 10 bis 60 Sekunden.

Das Erwärmen der belichteten Zusammensetzungen kann in herkömmlichen Konvektionsöfen stattfinden. Sind kurze Erhitzungs- oder Reaktionszeiten erforderlich, so kann das Erhitzen durch Belichtung mit beispielsweise IR-Strahlung, IR-Lasern oder Mikrowellengeräten erfolgen. Die Polymerisationstemperaturen liegen im Bereich von Raumtemperatur bis etwa 80°C.

Die erfindungsgemässen Zusammensetzungen können auch weitere, bekannte und üblicherweise in der Technik photopolymerisierbarer Materialien eingesetzte Zusatzstoffe enthalten. Beispiele für solche Zusatzstoffe sind Pigmente, Farbstoffe, Füllstoffe und Verstärkungsmittel, Glasfasern und sonstige Fasern, Flammhemmstoffe, Antistatika, Verlaufmittel, Antioxydantien und Lichtschutzmittel, sowie herkömmliche Photoinitiatoren wie Acetophenone, Acylphosphinoxyde oder aromatische Ketone. Um die Endeigenschaften von Epoxidharzen zu verbessern, kann man polyfunktionelle Hydroxylverbindungen, zum Beispiel wie in der deutschen Offenlegungsschrift 2 639 395 beschrieben, einarbeiten.

Zur Erhöhung der Lagerfähigkeit im Dunkeln können die härtbaren Zusammensetzungen schwache organische Basen wie Nitrile, Amide, Lactone oder Harnstoffderivate enthalten. Um vorzeitige Reaktion durch unbeabsichtigte Belichtung zu vermeiden, kann man kleine Mengen UV-Absorptionsmittel und/oder organische Farbstoffe zusetzen.

Die erfindungsgemässe Zusammensetzung kann nach üblichen Methoden auf mindestens eine Oberfläche eines Trägermaterials aufgebracht werden. Das beschichtete Material ist ebenfalls ein Gegenstand der Erfindung. Geeignete Träger sind z.B. Metalle und Halbmetalle wie Stahl, Aluminium, Kupfer, Cadmium, Zink, Silicium, sowie Keramik, Glas, Kunststoffe, Papier und Holz. Das beschichtete Material kann zur Herstellung von Schutzschichten und Passivierschichten durch Belichtung verwendet werden, was ein weiterer Gegenstand der Erfindung ist.

Wird bei der Belichtung nur ein Teil der Beschichtung durch eine Photomaske bestrahlt, so können die unbelichteten Stellen anschliessend mit einem geeigneten Lösungsmittel entfernt werden. Das beschichtete Material eignet sich somit auch als photographisches Aufzeichnungsmaterial, zur Herstellung von Druckplatten und besonders gedruckten Schaltungen sowie als Lötstopplack. Die Verwendung als photographisches Aufzeichnungsmaterial ist ebenfalls ein Gegenstand vorliegender Erfindung.

Die erfindungsgemässen Zusammensetzungen sind auch als Klebstoffe oder zur Herstellung von Kitten, Füllstoffen oder faserverstärkten Verbundstoffen und Schichtkörpern verwendbar.

Die erfindungsgemässen Zusammensetzungen weisen eine hohe Lichtempfindlichkeit ohne weitere Sensibilisierung auf, was zudem für die Aushärtung kurze Belichtungszeiten bedeutet. Gleichzeitig werden kationisch und radikalisch wirksame Initiatoren bei der Belichtung erzeugt, was den Anwendungsbereich bezüglich der polymerisierbaren Materialien erweitert. Es überrascht hierbei, dass das Oxidationsmittel erst nach der Belichtung wirksam wird und eine Härtung durch Bestrahlung ermöglicht. Es ist sehr vorteilhaft, dass die Aushärtung im allgemeinen durch die Einwirkung von Strahlung ohne äussere Wärmezufuhr erfolgt.

Die nachfolgenden Beispiele erläutern die Erfindung näher.

*Beispiele 1-11:*

2,5 mg einer 50 μ mol Verbindung der Formel I und 250 μ mol Oxidationsmittel pro g Epoxidharz enthaltenden Lösung wird in einem Aluminiumtiegel bei

0°C mit einer 1000 W Hg-Hochdrucklampe bestrahlt. Der verschlossene Tiegel wird in ein Differential-Scanning-Calorimeter (DSC-30, Mettler) überführt und mit einer Aufheizrate von 20°C/min aufgeheizt. Dabei werden bestimmt: Beginn der exothermen Reaktion ($T_{Start}$); Freiwerdende Reaktionsenthalpie ($\Delta E$) und Temperatur bei maximaler Reaktionsenthalpie ($T_{max}$).

Als Epoxidharze werden eingesetzt:

1) Technischer Bisphenol-A-diglycidyläther mit einem Epoxidgehalt von 5,2 Äqu/kg.

2) Technisches cycloaliphatisches Epoxid der Formel

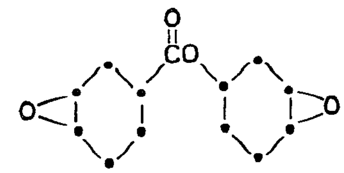

3) Glycidylisierter Kresol-Novolak mit einem Epoxidgehalt von 4,8 Äqu./kg.

Die Bestandteile und Ergebnisse sind in folgender Tabelle zusammengefasst. Man erkennt, dass die Polymerisation im Bereich der Raumtemperatur beginnt und bei niedrigen Temperaturen, die nur wenig über der Starttemperatur liegen, vollständig abläuft.

TABELLE

| Beispiel | Oxidationsmittel | Verbindung der Formel I | Epoxidharz | Belichtungszeit [s/°C] | DSC-Experiment | | |
|---|---|---|---|---|---|---|---|
| | | | | | $T_{Start}$ °C | $T_{max}$ °C | $\Delta E$(J/g) |
| 1 | Tertiärbutylhydroperoxid | ($\eta^6$-Naphthalin) ($\eta^5$-cyclopentadienyl) Fe(II)-hexafluorophosphat | 1 | 30/0 | 30 | 46 | 299 |
| 2 | Tertiärbutylhydroperoxid | ($\eta^6$-Naphthalin) ($\eta^5$-cyclopentadienyl Fe(II)-tetrafluoroborat | 1 | 30/0 | 20 | 53 | 187 |
| 3 | Tertiärbutylhydroperoxid | ($\eta^6$-Naphthalin) ($\eta^5$-cyclopentadienyl) Fe(II)-hexafluorantimonat | 1 | 30/0 | 30 | 51 | 253 |
| 4 | Tertiärbutylhydroperoxid | ($\eta^6$-Naphthalin) ($\eta^5$-cyclopentadienyl) Fe(II)-hexafluoroarsenat | 1 | 30/0 | 30 | 47 | 253 |
| 5 | Cumolhydroperoxid | gemäss Beispiel 1 | 1 | 180/0 | 20 | 38 | 294 |
| 6 | m-Chlorperbenzoesäure | gemäss Beispiel 1 | 1 | 180/0 | 20 | 38 | 294 |
| 7 | Benzochinon | gemäss Beispiel 1 | 1 | 180/0 | 55 | 79 | 252 |
| 8 | Tertiärbutylhydroperoxid | gemäss Beispiel 1 | 3 | 180/20 | 30 | 50 | 144 |
| 9 | Perbenzoesäure | gemäss Beispiel 1 | 2 | 180/0 | 20 | 54 | 91 |
| 10 | Tertiärbutylhxdroperoxid | ($\eta^6$-p-Chlortoluol) ($\eta^5$-cyclopentadienyl) Fe(II)hexafluorophosphat | 1 | 90/0 | 35 | 46 | 315 |
| 11 | Tertiärbutylhydroperoxid | ($\eta^6$-Pyren)($\eta^5$-cyclopentadienyl)Fe(II)-hexafluorophosphat | 1 | 10/0 | 30 | 47 | 258 |

*Beispiel 12*

Eine Lösung aus 2 g eines technischen Bisphenol-A-diglycidyläthers (Epoxidgehalt: 5,2 Äqu./kg), 0,1 mmol ($\eta^6$-Naphthalin)-($\eta^5$-cyclopentadienyl)-eisen-(II)-hexafluorophosphat und 0,5 mmol Cumolhydroperoxid werden mit einer 25 µm Rakel auf eine kupferkaschierte Epoxidplatte aufgebracht. Nach Belichten während 30 s (Abstand ca. 50 cm) mit einem 5000 W Metallhalogenidbrenner erhält man einen klebfreien, acetonbeständigen Film.

*Beispiel 13:*

Beispiel 12 wird wiederholt mit Tertiärbutylhydroperoxid anstelle von Cumolhydroperoxid. Man erhält das gleiche Ergebnis.

*Beispiel 14:*

Eine Lösung aus 2 g einer Mischung von 48 Teilen Polyesteracrylat, 32 Teilen Butandioldiacrylat sowie 20 Teilen Dicyclopentadienyloxyäthylacrylat, 0,1 mmol ($\eta^6$-2-Propylbenzol)-($\eta^5$-cyclopentadienyl)eisen(II)-hexafluorophosphat und 0,5 mmol Tertiärbutylhydroperoxid wird mit einer 50 µm Rakel auf einer Glasplatte aufgebracht. Nach Bestrahlen (30 s, Abstand ca. 50 cm) mit einer 1000 W Halogenlampe erhält man einen klebfreien Film.

**Patentansprüche**

1. Härtbare Zusammensetzung, enthaltend

a) ein radikalisch oder kationisch polymerisierbares Material, Gemische dieser Materialien oder ein radikalisch und kationisch polymerisierbares Material

b) mindestens eine Eisenverbindung der Formel I

$$[(R^1)(R^2Fe^{II})_a]^{+a} \ \frac{a}{q} \ (LQ_m)^{-q} \qquad (I)$$

worin

a 1 oder 2 und q 1, 2 oder 3 sind,
L ein zweiwertiges bis siebenwertiges Metall oder Nichtmetall bedeutet,
Q für ein Halogenatom steht,
m eine ganze Zahl ist, die der Summe der Wertigkeit von L und q entspricht,
$R^1$ ein $\pi$-Aren und $R^2$ das Anion eines $\pi$-Arens bedeuten, und

c) mindestens einen Elektronenacceptor als Oxidationsmittel.

2. Zusammensetzungen nach Anspruch 1, dadurch gekennzeichnet, dass $R^1$ aromatische Gruppen mit 6 bis 24 Kohlenstoffatomen oder heteroaromatische Gruppen mit 3 bis 20 Kohlenstoffatomen darstellt, wobei diese Gruppen unsubstituiert oder durch gleiche oder verschiedene Halogenatome, $C_{1-8}$ -Alkyl-, $C_2$-$C_8$-Alkenyl, $C_2$-$C_8$-Alkinyl, $C_{1-8}$-Alkoxy-, Cyan-, $C_{1-8}$-Alkylthio-, $C_{2-6}$-Monocarbonsäureester-, Phenyl-, $C_{2-5}$-Alkanoyl- oder Benzoylgruppen einfach oder mehrfach substituiert sind.

3. Zusammensetzungen nach Anspruch 1, dadurch gekennzeichnet, dass $R^2$ das Anion eines arometischen $\pi$-Arens mit 6 bis 24 Kohlenstoffatomen oder eines heteroaromatischen $\pi$-Arens mit 3 bis 20 Kohlenstoffatomen darstellt, welches jeweils unsubstituiert oder durch gleiche oder verschiedene $C_{1-8}$ -Alkyl-, $C_2$-$C_8$-Alkenyl, $C_2$-$C_8$-Alkinyl, $C_{2-6}$--Monocarbonsäureester-, Cyan-, $C_{2-5}$-Alkanoyl- oder Benzoylgruppen einfach oder mehrfach substituiert ist.

4. Zusammensetzungen nach Anspruch 1, dadurch gekennzeichnet, dass a 1 ist sowie $R^1$ für Benzol, Toluol, Xylol, Methoxybenzol, Chlorbenzol, p-Chlortoluol, Cumol, Naphthalin, Methylnaphthalin, Chlornaphthalin, Methoxynaphthalin, Biphenyl, Inden, Pyren, Perylen oder Diphenylensulfid und $R^2$ für das Anion des Cyclopentadiens, Acetylcyclopentadiens, Methylcyclopentadiens, Phenylcyclopentadiens oder Indens stehen.

5. Zusammensetzungen nach Anspruch 1, dadurch gekennzeichnet, dass a 1 ist, $R^1$ $\eta^6$-Pyren oder $\eta^6$-Naphthalin und $R^2$ das Anion des $\eta^5$-Cyclopentadiens darstellen.

6. Zusammensetzungen nach Anspruch 1, dadurch gekennzeichnet, dass $[LQ_m]^{-q}$ $SbF_6^-$, $BF_4^-$, $AsF_6^-$ oder $PF_6^-$ ist.

7. Zusammensetzungen nach Anspruch 1, dadurch gekennzeichnet, dass das Oxidationsmittel ein organisches Hydroperoxid, eine organische Persäure oder ein Chinon ist.

8. Zusammensetzung gemäss Anspruch 7, dadurch gekennzeichnet, dass das Oxidationsmittel Tertiärbutylhydroperoxid, Cumolhydroperoxid, Triphenylmethylhydroperoxid, Tetralinhydroperoxid, α-Methyltetralinhydroperoxid, Decalinhydroperoxid, Perbenzoesäure, m-Chlorperbenzoesäure oder Benzochinon ist.

9. Zusammensetzung nach Anspruch 1, dadurch gekennzeichnet, dass das kationisch polymerisierbare organische Material ein Epoxidharz ist.

10. Zusammensetzung nach Anspruch 1, dadurch gekennzeichnet, dass das radikalisch polymerisierbare Material eine mono- oder polyäthylenisch ungesättigte Verbindung ist.

11. Zusammensetzung gemäss Anspruch 1, dadurch gekennzeichnet, dass das kationisch und radikalisch polymerisierbare Material eine Mischung aus einem Epoxidharz und einer mono- oder polyäthylenisch ungesättigten Verbindung oder ein Teilester eines Epoxidharzes und Acrylsäure, Methacrylsäure oder einer Mischung der Säuren ist.

12. Zusammensetzung nach Anspruch 1, dadurch gekennzeichnet, dass sie die Eisenverbindung b) und das Oxidationsmittel c) in einer Menge von 0,1 bis 15 Gew.-%, bezogen auf das polymerisierbare organische Material, enthält.

13. Zusammensetzung gemäss Anspruch 12, dadurch gekennzeichnet, dass das Gewichtsverhältnis der Eisenverbindung b) zu dem Oxidationsmittel c) von 1:10 bis 5:1 beträgt.

14. Verfahren zum Polymerisieren eines radikalisch oder kationisch polymerisierbaren Materials, einer Mischung dieser Materialien oder eines radikalisch und kationisch polymerisierbaren Materials unter Einwirkung von Strahlung in Gegenwart eines Photoinitiators und gegebenenfalls unter Erwärmen, dadurch gekennzeichnet, dass der Photoinitiator eine Mischung aus

a) mindestens einer Eisenverbindung der Formel I

$$[(R^1)(R^2Fe^{II})_a]^{+a} \ \frac{a}{q} \ (LQ_m)^{-q} \qquad (I)$$

worin

a 1 oder 2 und q 1, 2 oder 3 sind,
L ein zweiwertiges bis siebenwertiges Metall oder Nichtmetall bedeutet,
Q für ein Halogenatom steht,
m eine ganze Zahl ist, die der Summe der Wertigkeit von L und q entspricht,
$R^1$ ein $\pi$-Aren und $R^2$ das Anion eines $\pi$-Arens bedeutet, und

b) mindestens einem Elektronenacceptor als Oxidationsmittel, ist, und dass man gegebenenfalls danach die Polymerisationsreaktion durch Wärmezufuhr vervollständigt.

15. Beschichtetes Material, dadurch gekennzeichnet, dass auf einem Träger eine Schicht der Zusammensetzung gemäss Anspruch 1 aufgebracht ist.

16. Verwendung des Materials gemäss Anspruch 15 zur Herstellung von Schutzüberzügen und als photographisches Aufzeichnungsmaterial.

17. Verfahren zur Herstellung von photographischen Reliefabbildungen, dadurch gekennzeichnet, dass man ein Material nach Anspruch 15 durch eine Photomaske bestrahlt, gegebenenfalls unter Erwärmen, und danach die unbelichteten Anteile mit einem Entwickler entfernt.

**Claims**

1. A curable composition containing a) a material which can be polymerised by free radicals or cations, mixtures of these materials or a material which can be polymerised by free radicals and cations, b) at least one iron compound of the formula I

$$[(R^1)(R^2Fe^{II})_a]^{+a} \quad \frac{a}{q} \quad (LQ_m)^{-q} \qquad (I)$$

in which a is 1 or 2 and q is 1, 2 or 3, L is a divalent to heptavalent metal or non-metal, Q is a halogen atom, m is an integer corresponding to the sum of the valencies of L and q, $R^1$ is a $\pi$-arene and $R^2$ is the anion of a $\pi$-arene, and c) at least one electron acceptor as an oxidising agent.

2. A composition according to claim 1, wherein $R^1$ is an aromatic group having 6 to 24 carbon atoms or a heteroaromatic group having 3 to 20 carbon atoms, these groups being unsubstituted or substituted by one or more identical or different members selected from the series consisting of halogen atoms, $C_{1-8}$-alkyl, $C_2$-$C_8$-alkenyl, $C_2$-$C_8$-alkynyl, $C_{1-8}$-alkoxy, cyano, $C_{1-8}$-alkylthio, $C_{2-6}$-monocarboxylic acid ester, phenyl, $C_{2-5}$-alkanoyl and benzoyl groups.

3. A composition according to claim 1, wherein $R^2$ is the anion of an aromatic $\pi$-arene having 6 to 24 carbon atoms or of a hetero-aromatic $\pi$-arene having 3 to 20 carbon atoms, each of these being unsubstituted or substituted by one or more identical or different members selected from the series consisting of $C_{1-8}$-alkyl, $C_2$-$C_8$-alkenyl, $C_2$-$C_8$-alkynyl, $C_{2-6}$-monocarboxylic acid ester, cyano, $C_{2-5}$--alkanoyl and benzoyl groups.

4. A composition according to claim 1, wherein a is 1 and $R^1$ is benzene, toluene, xylene, methoxybenzene, chlorobenzene, p-chlorotoluene, cumene, naphthalene, methylnaphthalene, chloronaphthalene, methoxynaphthalene, biphenyl, indene, pyrene, perylene or diphenylene sulfide and $R^2$ is the anion of cyclopentadiene, acetylcyclopentadiene, methylcyclopentadiene, phenylcyclopentadiene or indene.

5. A composition according to claim 1, wherein a is 1, $R^1$ is $\eta^6$-pyrene or $\eta^6$-naphthalene and $R^2$ is the anion of $\eta^5$-cyclopentadiene.

6. A composition according to claim 1, wherein $[LQ_m]^{-q}$ is $SbF_6^-$, $BF_4^-$, $AsF_6^-$ or $PF_6^-$.

7. A composition according to claim 1, wherein the oxidising agent is an organic hydroperoxide, an organic peracid or a quinone.

8. A composition according to claim 7, wherein the oxidising agent is tert-butyl hydroperoxide, cumene hydroperoxide, triphenylmethyl hydroperoxide, tetralin hydroperoxide, $\alpha$-methyltetralin hydroperoxide, decalin hydroperoxide, perbenzoic acid, m-chloroperbenzoic acid or benzoquinone.

9. A composition according to claim 1, wherein the organic material which can be polymerised by cations is an epoxy resin.

10. A composition according to claim 1, wherein the material which can be polymerised by free radicals is a monoethylenically or polyethylenically unsaturated compound.

11. A composition according to claim 1, wherein the material which can be polymerised by cations and free radicals is a mixture of an epoxy resin and a monoethylenically or polyethylenically unsaturated compound or a partial ester of an epoxy resin and acrylic acid, methacrylic acid or a mixture of these acids.

12. A composition according to claim 1, which contains the iron compound b) and the oxidising agent c) in an amount of 0.1 to 15% by weight, based on the polymerisable organic material.

13. A composition according to claim 12, wherein the ratio by weight of the iron compound b) to the oxidising agent c) is in the range from 1:10 to 5:1.

14. A process for the polymerisation of a material which can be polymerised by free radicals or cations, a mixture of these materials or a material which can be polymerised by free radicals and cations, by the action of radiation in the presence of a photoinitiator and, if appropriate, by heating, in which process the photoinitiator is a mixture of a) at least one iron compound of the formula I

$$[(R^1)(R^2Fe^{II})_a]^{+a} \quad \frac{a}{q} \quad (LQ_m)^{-q} \qquad (I)$$

in which a is 1 or 2 and q is 1, 2 or 3, L is a divalent to heptavalent metal or non-metal, Q is a halogen atom, M is an integer corresponding to the sum of the valencies of L and q, $R^1$ is a $\pi$-arene and $R^2$ is the anion of a $\pi$-arene, and b) at least one electron acceptor as the oxidising agent and, if desired, polymerisation is completed subsequently by the application of heat.

15. A coated material wherein a layer of the composition according to claim 1 has been applied to a substrate.

16. Use of the material according to claim 15 for the production of protective coatings and as a photographic recording material.

17. A process for the production of photographic relief images, which comprises irradiating a material according to claim 15 through a photomask, if appropriate while heating, and then removing the unexposed portions with a developer.

## Revendications

1. Composition durcissable comprenant:

a) une matière polymérisable par voie radicalaire ou cationique, un mélange de ces matières ou une matière polymérisable à la fois par voie radicalaire et cationique,

b) un ou plusieurs composés du fer de formule I ci-dessous

$$[(R^1)(R^2Fe^{II})_a]^{+a} \frac{a}{q} (LQ_m)^{-q} \quad (I),$$

dans laquelle

a est le nombre 1 ou 2 et q le nombre 1, 2 ou 3,

L représente un métal ou un métalloïde divalent à heptavalent,

Q un atome d'halogène,

m un nombre entier correspondant à la somme de la valence de L et de q,

$R^1$ représente un π-arène et $R^2$ l'anion d'un π-arène, et

c) un ou plusieurs accepteurs d'électrons comme agent oxydant.

2. Composition selon la revendication 1 caractérisée en ce que dans la formule indiquée $R^1$ est un groupe aromatique en $C_6$ à $C_{24}$ ou un groupe hétéroaromatique en $C_3$ à $C_{20}$, groupes qui sont sans substituants ou qui peuvent avoir un ou plusieurs substituants identiques ou différents pris parmi des atomes d'halogènes et des groupes alkyles en $C_1$-$C_8$, alcényles en $C_2$-$C_8$, alcynyles en $C_2$-$C_8$, alcoxy en $C_1$-$C_8$, cyano, alkylthio en $C_1$-$C_8$, esters d'acides monocarboxyliques en $C_2$-$C_6$, phényle, alcanoyles en $C_2$-$C_5$ et benzoyle.

3. Composition selon la revendication 1, caractérisée en ce que $R^2$ est l'anion d'un π-arène aromatique en $C_6$ à $C_{24}$ ou d'un π-arène hétéroaromatique en $C_3$ à $C_{20}$ qui peuvent être sans substituants ou avoir un ou plusieurs substituants identiques ou différents pris parmi des groupes alkyles en $C_1$-$C_8$, alcényles en $C_2$-$C_8$, alcynyles en $C_2$-$C_8$, esters d'acides monocarboxyliques en $C_2$-$C_6$, cyano, alcanoyles en $C_2$-$C_5$ et benzoyles.

4. Composition selon la revendication 1, caractérisée en ce que a est le nombre 1, $R^1$ représente le benzène, le toluène, un xylène, le méthoxybenzène, le chlorobenzène, le p-chlorotoluène, le cumène, le naphthalène, le méthylnaphthalène, le chloronaphthalène, le méthoxynaphthalène, le biphényle, l'indène, le pyrène, le perylène ou le sulfure de diphénylène, et $R^2$ l'anion du cyclopentadiène, de l'acétylcyclopentadiène, du méthylcyclopentadiène, du phénylcyclopentadiène ou de l'indène.

5. Composition selon la revendication 1, caractérisée en ce que a est le nombre 1, $R^1$ est le $\eta^6$-pyrène ou le $\eta^6$-naphthalène et $R^2$ l'anion du $\eta^5$-cyclopentadiène.

6. Composition selon la revendication 1, caractérisée en ce que $[LQ_m]^{-q}$ représente $SbF_6^-$, $BF_4^-$, $AsF_6^-$ ou $PF_6^-$.

7. Composition selon la revendication 1 caractérisée en ce que l'agent oxydant est un hydroperoxyde organique, un peracide organique ou un quinone.

8. Composition selon la revendication 7, caractérisée ne ce que l'agent oxydant est l'hydroperoxyde de butyle tertiaire, de cumène, de triphénylméthyle, de tétraline, d'α-méthyltétraline ou de décaline ou bien l'acide perbenzoïque, l'acide m-chloroperbenzoïque ou la benzoquinone.

9. Composition selon la revendication 1, caractérisée en ce que la matière organique polymérisable par voie cationique est une résine époxyde.

10. Composition selon la revendication 1, caractérisée en ce que la matière polymérisable par voie radicalaire est un composé ayant une ou plusieurs insaturations éthyléniques.

11. Compositions selon la revendication 1, caractérisée en ce que la matière polymérisable par voies cationique et radicalaire est un mélange d'une résine époxyde et d'un composé avec une ou plusieurs insaturations éthyléniques ou bien un ester partiel d'une résine époxyde et d'acide acrylique ou méthacrylique ou de ces deux acides à la fois.

12. Composition selon la revendication 1, caractérisée en ce qu'elle contient une proportion du composé de fer b) et de l'agent oxydant c) de 0,1 à 15% du poids de la matière organique polymérisable.

13. Composition selon la revendication 12, caractérisée en ce que le rapport pondéral du composé de fer b) à l'agent oxydant c) est compris entre 1:10 et 5:1.

14. Procédé de polymérisation d'une matière polymérisable par voie radicalaire ou cationique, d'un mélange de ces matières ou d'une matière polymérisable à la fois par voie radicalaire et cationique, sous l'effet d'une irradiation et en présence d'un photoinducteur et le cas échéant avec chauffage, procédé caractérisé en ce que le photoinducteur est un mélange de:

a) un ou plusieurs composés du fer de formule I ci-dessous

$$[(R^1)(R^2Fe^{II})_a]^{+a} \frac{a}{q} (LQ_m)^{-q} \quad (I)$$

dans laquelle

a est le nombre 1 ou 2 et q le nombre 1, 2 ou 3,

L représente un métal ou un métalloïde divalent à heptavalent,

Q un atome d'halogène,

m un nombre entier correspondant à la somme de la valence de L et de q,

$R^1$ représente un π-arène et $R^2$ l'anion d'un π-arène, et

b) un ou plusieurs accepteurs d'électrons comme agent oxydant, et en ce que, le cas échéant, on conduit à son terme la réaction de polymérisation par un apport de chaleur extérieure.

15. Matière enduite formée d'un substrat sur lequel on a appliqué une couche d'une composition selon la revendication 1.

16. Utilisation d'une matière selon la revendication 15 pour former des revêtements protecteurs et comme matière photographique d'enregistrement.

17. Procédé de production de clichés photographiques en relief, caractérisé en ce que l'on irradie une matière selon la revendication 15 à travers un photomasque, éventuellement en la chauffant, puis on élimine avec un produit de développement (révélateur) les parties qui n'ont pas été irradiées.